(19) Europäisches Patentamt / European Patent Office / Office européen des brevets

(11) **EP 2 667 204 A1**

(12) **EUROPEAN PATENT APPLICATION**

(43) Date of publication:
**27.11.2013 Bulletin 2013/48**

(51) Int Cl.:
***G01R 13/02*** *(2006.01)*

(21) Application number: **13168607.3**

(22) Date of filing: **21.05.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **24.05.2012 US 201213480294**

(71) Applicant: **Tektronix, Inc.**
**Beaverton, Oregon 97077-0001 (US)**

(72) Inventors:
- **Dobyns, Kenneth P.**
  **Beaverton, OR 97008 (US)**
- **Veith, Kristie L.**
  **Beaverton,, OR 97006 (US)**

(74) Representative: **Brinck, David John Borchardt et al**
**R.G.C. Jenkins & Co**
**26 Caxton Street**
**London SW1H 0RJ (GB)**

(54) **Time-domain triggering in a test and measurement instrument**

(57) A test and measurement instrument converts digital data that represents an analog input signal into a time-domain bitmap (205), and then compares a region of that time-domain bitmap to a density threshold (210). When the density value violates the density threshold, a trigger signal is generated that causes digital data to be stored into a memory.

200
205
215
225
230
235
210
Circular Buffer
Waveform Memory
Rasterizer
Waveform Combiner
Region Evaluator
Trigger signal
Event Trigger Detector
Density threshold
220

Figure 2

EP 2 667 204 A1

## Description

FIELD OF THE INVENTION

The present invention relates to test and measurement instruments, and more particularly to trigger circuits for test and measurement instruments.

BACKGROUND OF THE INVENTION

Oscilloscopes use trigger circuits to detect, and thereby permit the display of, various types of signals. There are numerous kinds of trigger circuits. For example, oscilloscopes use edge triggers, pulse width triggers, serial data triggers, and so on.

In some cases, the user of an oscilloscope may want to detect an extremely subtle variation in the statistical properties of a signal. For example, the user may want to trigger when the statistical profile of a signal deviates from a Gaussian distribution. However, no conventional trigger is capable of detecting such a phenomenon.

What is needed is a way to trigger on the statistical variation of an input signal.

SUMMARY OF THE INVENTION

Aspects of the invention are set out in the accompanying claims. A test and measurement instrument according to an embodiment of the present invention processes digital data that represents an analog input signal to generate a time-domain bitmap, and then compares a region of that time-domain bitmap to a density threshold. When the density value violates the density threshold, a trigger signal is generated that causes digital data to be stored into a memory.

The objects, advantages, and other novel features of the present invention are apparent from the following detailed description when read in conjunction with the appended claims and attached drawings.

BRIEF DESCRIPTION OF THE DRAWINGS

FIG. 1 depicts a high-level block diagram of a conventional test and measurement instrument.

FIG. 2 depicts a high-level block diagram of a trigger detector according to an embodiment of the present invention.

FIG. 3 illustrates the steps of creating a time-domain bitmap according to an embodiment of the present invention.

FIG. 4 depicts a time-domain bitmap according to an embodiment of the present invention.

DETAILED DESCRIPTION OF THE INVENTION

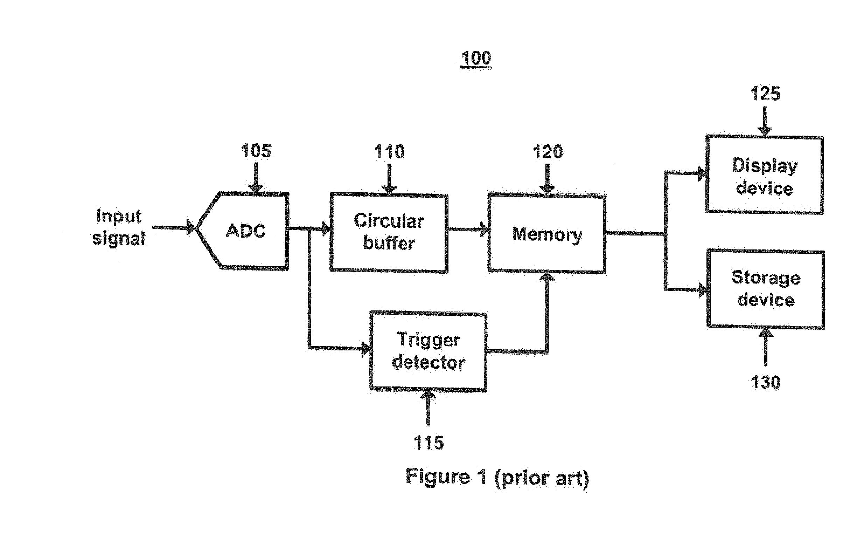

FIG. 1 depicts a conventional test and measurement instrument 100. An analog-to-digital converter (ADC) 105 receives an analog input signal and digitizes it to produce a continuous stream of digital data that represents the analog values of the input signal at the sampling instants. The digital data is input to a circular buffer 110 and also input to a trigger detector 115 that monitors the digital data to determine if a predefined condition is satisfied. When the predefined condition is satisfied, the trigger detector 115 generates a trigger signal that causes an acquisition memory 120 to store the digital data held in the circular buffer 110. The stored digital data may then be displayed on a display device 125 or stored in a storage device 130. The test and measurement instrument 100 represents any one of various test and measurement instruments such as an oscilloscope, a real-time spectrum analyzer, and the like. As such, instrument-specific elements such as pre-amplifiers, down-converters, etc. are not shown for simplicity.

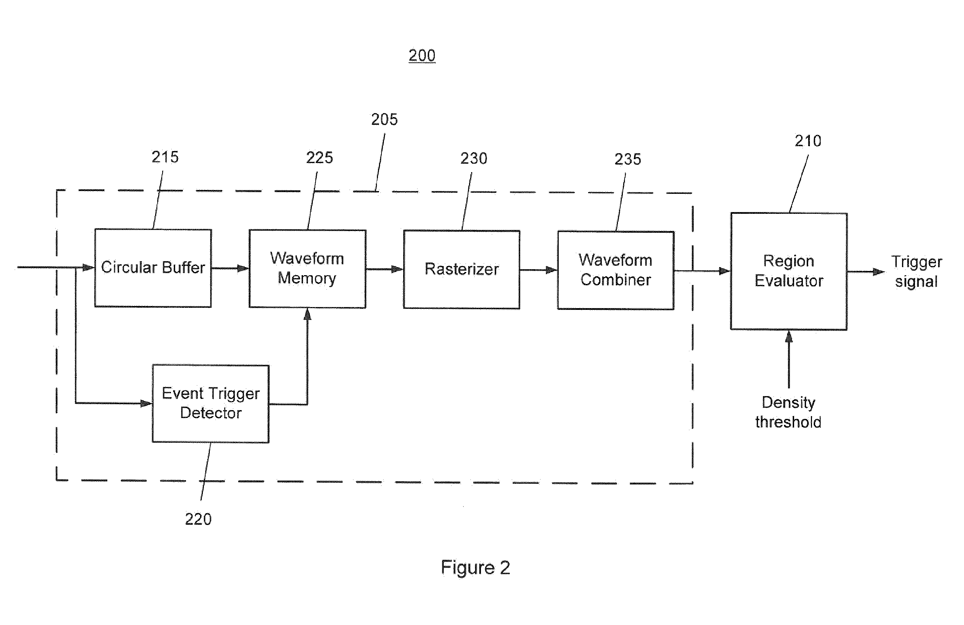

Now, in an embodiment of the present invention, a test and measurement instrument includes a trigger detector 200 as shown in FIG. 2. A time-domain bitmap generator 205 receives digital data and processes it to generate a time-domain bitmap (or simply, a bitmap). A region evaluator 210 then compares a density value of a region of the bitmap with a density threshold. When the density value violates the density threshold, the region evaluator 210 generates a trigger signal. The time-domain bitmap generator 205 and the region evaluator 210 are described in more detail below.

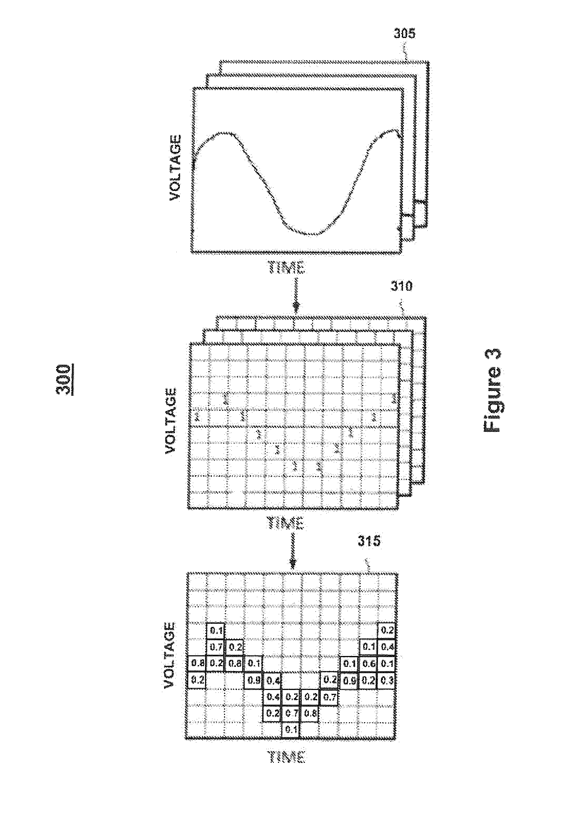

The time-domain bitmap generator 205 processes the stream of digital data to produce a bitmap as illustrated in FIG. 3. As shown in Figure 2, digital data input to the time-domain bitmap generator 205 is input to a circular buffer 215 and an event trigger detector 220. The event trigger detector 220 detects the occurrence of an event in a conventional manner, e.g. edge detection, pulse width detection or serial data detection. When an event is detected, the event trigger detector 220 generates an event trigger signal that causes a waveform memory 225 to store the digital data held in the circular buffer 215. In this way, the stream of digital data is segmented into a series of waveforms 305, as shown in Figure 3, stored in the waveform memory 225.

Each waveform 305 stored in the waveform memory 225 is rasterized by a rasterizer 230 to produce a rasterized waveform 310. A rasterized waveform 310 comprises a plurality of cells arranged in an array of rows and columns, with each row representing a particular voltage amplitude value and each column representing a particular time value. The value of each cell is either a "1", also referred to as a "hit", which indicates that the input signal was present at that particular location in voltage amplitude versus time or a "0", which indicates that it was not. The values of the corresponding cells of the rasterized waveforms 310 are summed together by a waveform combiner 235 and then divided by the number of waveforms to form a time-domain bitmap 315. In some embodiments, when a new bitmap is created, the previously created bitmap is discarded and replaced with the newly created bitmap. In other embodiments, newly created bitmaps are accumulated into, i.e., combined with, the previously created bitmap.

The density value of a cell of the time-domain bitmap 315 equals the number of hits within the cell divided by the number of waveforms used to generate it. In other words,

$$\text{Density value of a cell} = \frac{\textit{Number of hits}}{\textit{Number of waveforms}}$$

The density value of a region of the time domain bitmap 315 equals the sum of the density values of all of the cells within the region divided by the number of cells bound by the region. In other words,

$$\text{Density value of a region} = \frac{\textit{Sum of density values of all cells within the region}}{\textit{Number of cells bounded by the region}}$$

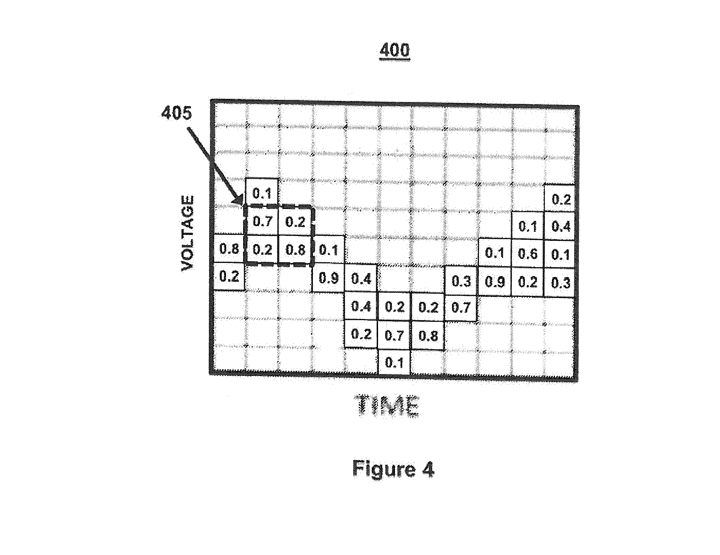

For example, consider FIG. 4 which depicts a time-domain bitmap 400 according to an embodiment of the present invention. A region 405 spans 2 x 2 = 4 cells of the bitmap 400, however, it could alternatively span any number of cells, such as 1 x 1 cells, 3 x 5 cells, and so on. The density value of the region 410 equals ((0.7 + 0.2 + 0.2 + 0.8) = 1.9) / 4 = 0.475. The region evaluator 210 compares this density value to a density threshold, and generates a trigger signal if the density value violates the density threshold. "Violate" may be programmed to mean either "exceeds" or "is less than". So, for example, if the density threshold was 0.25, and if the region evaluator 210 was programmed to generate the trigger signal when the density value exceeds the density threshold, then the trigger signal would be generated because 0.475 exceeds 0.25. However, if the region evaluator 210 was programmed to generate the trigger signal when the density value is less than the density threshold, then the trigger signal would not be generated because 0.472 is not less than 0.25.

Using the various embodiments of the trigger detector shown and described above, a user may detect extremely subtle variations in the statistical properties of a signal, such as when the statistical profile of a signal deviates from a Gaussian distribution. For example, if the user knows that a signal having a Gaussian distribution should have a density value of 0.5 or less at a particular time and voltage location, then the user may program the trigger detector to detect when the density at that location exceeds 0.5.

As described above, the trigger detector 200 includes an event trigger detector 220 that processes digital data to detect an event and in response to detection of an event, generates an event trigger signal to store a waveform associated with the event. A plurality of such event waveforms are statistically processed to by the trigger detector 200, and in response to a statistical property being satisfied, digital data associated with that statistical property is stored by the test and measurement instrument.

In various embodiments, the location and size of the region of the bitmap may be specified by a user, specified by the test and measurement instrument, or specified by a standard. Similarly, in various embodiments, the density threshold may be defined a user, defined by the test and measurement instrument, or defined by a standard.

It will be appreciated that the various elements of the test and measurement instrument shown and described above may be implemented in hardware, software, or a combination of the two, and may comprise or be implemented on a general purpose microprocessor, a digital signal processor (DSP), an application specific integrated circuit (ASIC), a field-programmable gate array (FPGA), or the like.

It will be appreciated from the foregoing discussion that the present invention represents a significant advance in the field of test and measurement instruments. Although specific embodiments of the invention have been illustrated and described for purposes of illustration, it will be understood that various modifications may be made without departing from the spirit and scope of the invention. Accordingly, the invention should not be limited except as by the appended claims.

## Claims

1. A test and measurement instrument comprising:

   an analog-to-digital converter that digitizes an analog input signal to produce digital data;
   a trigger detector that processes the digital data in real-time and generates a trigger signal; and
   a memory that stores digital data in response to the trigger signal;
   the trigger detector comprising:

      a bitmap generator that converts the digital data into a time-domain bitmap; and
      a region evaluator that generates the trigger signal when a density value of a region of the time-domain bitmap violates a density threshold.

2. A test and measurement instrument as in claim 1 further comprising a display device that displays a representation of the digital data stored in the memory.

3. A test and measurement instrument as in claim 1 or 2 wherein the bitmap generator accumulates the time-domain bitmap into a previously created time-domain bitmap.

4. A test and measurement instrument as in any preceding claim wherein the region evaluator generates the trigger signal when a density value of a region of the time-domain bitmap exceeds the density threshold.

5. A test and measurement instrument as in any of claims 1 to 3, wherein the region evaluator generates the trigger signal when a density value of a region of the time-domain bitmap is less than the density threshold.

6. A test and measurement instrument as in any preceding claim wherein the density threshold is defined by a user, by the test and measurement instrument, or by a standard.

7. A test and measurement instrument as in any preceding claim, wherein the bitmap generator comprises:

   an event trigger detector that processes the digital data and generates a trigger signal upon the occurrence of a trigger event;
   a waveform memory that stores digital data for a waveform in response to the event trigger signal;
   a rasterizer that rasterizes waveforms stored by the waveform memory to generate rasterized waveforms; and
   a waveform combiner that generates the time-domain bitmap using a summation of the rasterized waveforms.

8. A method comprising the steps of:

   digitizing an analog input signal to produce digital data;
   processing the digital data to create a time-domain bitmap;
   generating a trigger signal when a density value of a region of the time-domain bitmap violates a density threshold; and
   storing digital data in a memory in response to the trigger signal.

9. A method as in claim 8 further comprising the step of displaying a representation of the digital data stored in the memory in response to the trigger signal.

10. A method as in claim 8 or 9 wherein the trigger signal is generated when the density valueexceeds the density threshold.

11. A method as in claim 8 or 9 wherein the trigger signal is generated when the density value is less than the density threshold.

12. A method as in any of claims 8 to 11 wherein the density threshold is defined by a user, by a test and measurement instrument, or by a standard.

13. A method as in any of claims 8 to 12 in which a location and size of the region of the bitmap is specified by a user, by a test and measurement instrument, or by a standard.

**14.** A method as in any of claims 8 to 13, wherein said processing of the digital data comprises:

processing the digital data and generating a trigger signal upon the occurrence of a trigger event;
storing digital data for a waveform in response to the event trigger signal;
rasterizing stored waveforms to generate rasterized waveforms; and
generating the time-domain bitmap using a summation of the rasterized waveforms.

**15.** A test and measurement instrument comprising:

an analog-to-digital converter that digitizes an analog input signal to produce digital data;
a trigger detector that processes the digital data in real-time and generates a trigger signal; and
a memory that stores digital data in response to the trigger signal;
the trigger detector comprising:

an event trigger detector that processes the digital data and generates an event trigger signal upon the occurrence of a trigger event;
a waveform memory that stores digital data for a waveform in response to the event trigger signal; and
a processor that processes waveforms for a plurality of trigger events to determine whether a predefined statistical condition is satisfied, and in response to the predefined statistical condition being satisfied generates the trigger signal.

100
Input signal
105
ADC
110
Circular buffer
115
Trigger detector
120
Memory
125
Display device
130
Storage device

Figure 1 (prior art)

200
205
215
Circular Buffer
220
Event Trigger Detector
225
Waveform Memory
230
Rasterizer
235
Waveform Combiner
210
Region Evaluator
Density threshold
Trigger signal

Figure 2

300
305
VOLTAGE
TIME
310
VOLTAGE
TIME
315
VOLTAGE
TIME

Figure 3

400
405
VOLTAGE
TIME

Figure 4

Europäisches Patentamt
European Patent Office
Office européen des brevets

# EUROPEAN SEARCH REPORT

Application Number
EP 13 16 8607

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 385 379 A2 (TEKTRONIX INC [US]) 9 November 2011 (2011-11-09)<br>* figure 1 *<br>* paragraphs [0002], [0007], [0018] *<br>* paragraphs [0029], [0030], [0032] *<br>* paragraphs [0033], [0035] *<br>* claims 1, 2 *<br>----- | 1-15 | INV.<br>G01R13/02 |
| X | US 2003/220753 A1 (PICKERD JOHN J [US] ET AL) 27 November 2003 (2003-11-27)<br>* figures 1-5 *<br>* paragraphs [0001], [0020], [0025] *<br>* paragraphs [0027], [0028], [0032] *<br>* paragraph [0034] *<br>* claims 1, 10 *<br>----- | 1-15 | |
| X | EP 2 228 661 A1 (TEKTRONIX INC [US]) 15 September 2010 (2010-09-15)<br>* figures 1, 5, 6 *<br>* paragraphs [0010], [0012], [0013] *<br>* paragraphs [0033], [0034], [0038] *<br>* paragraph [0040] *<br>* claims 1, 2, 8, 22 *<br>----- | 1-15 | TECHNICAL FIELDS SEARCHED (IPC)<br>G01R |
| A | EP 2 386 869 A2 (TEKTRONIX INC [US]) 16 November 2011 (2011-11-16)<br>* figures 1, 7 *<br>* paragraphs [0001], [0005], [0012] *<br>* paragraph [0033] *<br>----- | 1-15 | |
| A | US 2009/281759 A1 (CAKE ANTHONY [CH] ET AL) 12 November 2009 (2009-11-12)<br>* paragraphs [0038], [0044] *<br>----- | 1,8,15 | |
| A | US 5 841 286 A (STOOPS JOHN F [US]) 24 November 1998 (1998-11-24)<br>* column 2, line 14 - line 20 *<br>----- | 1,7,8,<br>14,15 | |

The present search report has been drawn up for all claims

1

| Place of search | Date of completion of the search | Examiner |
|---|---|---|
| Berlin | 6 September 2013 | Höller, Helmut |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 13 16 8607

This annex lists the patent family members relating to the patent documents cited in the above-mentioned European search report. The members are as contained in the European Patent Office EDP file on
The European Patent Office is in no way liable for these particulars which are merely given for the purpose of information.

06-09-2013

| Patent document cited in search report | Publication date | Patent family member(s) | Publication date |
|---|---|---|---|
| EP 2385379 A2 | 09-11-2011 | CN 102313841 A | 11-01-2012 |
| | | EP 2385379 A2 | 09-11-2011 |
| | | JP 2011237414 A | 24-11-2011 |
| | | US 2011273469 A1 | 10-11-2011 |
| US 2003220753 A1 | 27-11-2003 | JP 4532848 B2 | 25-08-2010 |
| | | JP 2003344454 A | 03-12-2003 |
| | | US 2003220753 A1 | 27-11-2003 |
| EP 2228661 A1 | 15-09-2010 | CN 101937019 A | 05-01-2011 |
| | | EP 2228661 A1 | 15-09-2010 |
| | | JP 2010217179 A | 30-09-2010 |
| | | US 2010235131 A1 | 16-09-2010 |
| EP 2386869 A2 | 16-11-2011 | CN 102331524 A | 25-01-2012 |
| | | EP 2386869 A2 | 16-11-2011 |
| | | JP 2011237424 A | 24-11-2011 |
| | | US 2011282610 A1 | 17-11-2011 |
| US 2009281759 A1 | 12-11-2009 | US 2009281759 A1 | 12-11-2009 |
| | | US 2012173188 A1 | 05-07-2012 |
| US 5841286 A | 24-11-1998 | JP 3016114 B2 | 06-03-2000 |
| | | JP H07151790 A | 16-06-1995 |
| | | US 5841286 A | 24-11-1998 |

EPO FORM P0459

For more details about this annex : see Official Journal of the European Patent Office, No. 12/82